# EUROPÄISCHE PATENTSCHRIFT

(11) **EP 0 607 845 B1**
(45) Veröffentlichungstag und Bekanntmachung des Hinweises auf die Patenterteilung: **27.09.1995**
(21) Anmeldenummer: 94100305.5
(22) Anmeldetag: 11.01.1994
(51) Int. Cl.: H05K 7/20

(54) **Einstückiges Isolierteil, insbesondere Spritzgiessteil**
One piece insulating part, especially injection molded part
Elément isolant en une pièce, en particulier une pièce fait par moulage par injection

(30) Priorität: 22.01.1993 DE 9300864 U
(43) Veröffentlichungstag der Anmeldung: 27.07.1994
(73) Patentinhaber: SIEMENS AKTIENGESELLSCHAFT, 80333 München (DE)
(72) Erfinder: Schönberger, Eduard, Dipl.-Ing. (FH), D-92245 Kümmersbruck (DE); Kasowski, Hermann, Dipl.-Ing. (FH), D-92280 Kastl (DE); Gruber, Stefan, Dipl.-Ing. (FH), D-92245 Kümmersbruck (DE); Schmidt, Heinz, Dipl.-Ing. (FH), D-92245 Kümmersbruck (DE)

(56) Entgegenhaltungen:
- EP-A- 0 306 412
- EP-A- 0 465 693
- US-A- 3 211 822

## Beschreibung

Die vorliegende Erfindung betrifft ein Isolierteil gemäß dem Oberbegriff des Anspruchs 1. Ein derartiges Isolierteil ist beispielsweise aus der EP 0 465 693 A1 bekannt. Auch beim Automatisierungsgerät SIMATIC S5-95 U der Siemens AG wird ein derartiges Isolierteil als Gehäuserückwand verwendet.

Aus konstruktiven Gründen kann es nötig sein, die als Kühlfläche wirkende Außenfläche von dem zu kühlenden elektronischen Bauelement entfernt anzuordnen. In diesem Fall stellt sich das Problem, trotz dieser voneinander entfernten Anordnung von Bauelement und Außenfläche eine wirksame Kühlung des Bauelements durch die Außenfläche zu gewährleisten. Das Problem wird durch das Kennzeichen des Anspruchs 1 gelöst.

Vorzugsweise ist die Außenfläche Teil einer Kühlrippe. Die Ausnehmung kann dann entweder an der Basis der Kühlrippe oder in der Kühlrippe selbst angeordnet sein. Eine Anordnung an der Basis der Kühlrippe ist besonders dann vorteilhaft, wenn die Abwärme des elektronischen Bauelements auf mehrere Außenflächen bzw. mehrere Kühlrippen verteilt werden soll.

Die Ausnehmung kann dabei durch das Wärmeleitelement nur teilweise oder auch vollständig verschlossen sein.

Das Wärmeleitelement ist vorzugsweise entweder als Metallisierung oder als Lötverbindung ausgebildet.

Weitere Vorteile und Einzelheiten ergeben sich aus der nachfolgenden Beschreibung eines Ausführungsbeispiels und in Verbindung mit den Zeichnungen. Dabei zeigen:

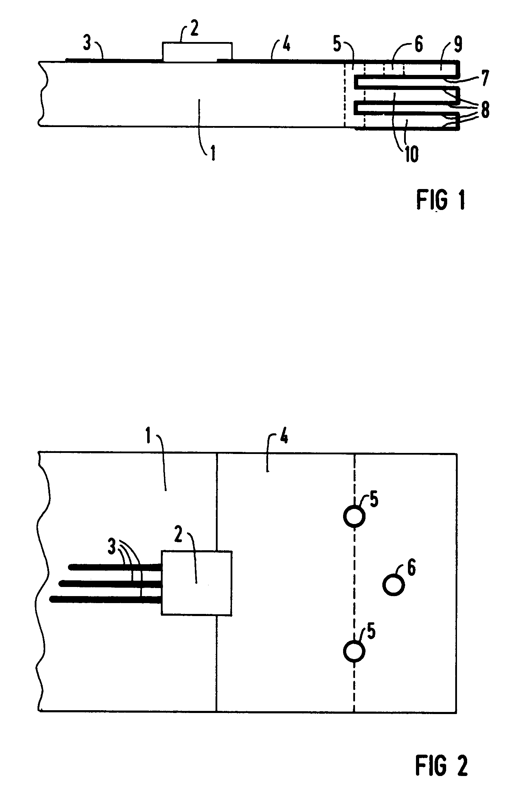

- FIG 1 und 2: eine Front- bzw. Draufsicht auf ein Kunststoffteil.

Gemäß den Figuren ist das als Schaltungsträger ausgebildete Spritzgießteil 1 mit elektronischen Bauelementen - dargestellt ist nur das Bauelement 2 - bestückt, die über Leiterzüge 3 elektrisch leitend miteinander verbunden sind. Die Leiterzüge 3 sind dabei dadurch entstanden, daß das Spritzgießteil 1 nach dem Spritzgießen großflächig metallisiert wurde und die Metallschicht dann zwischen den Leiterzügen 3 entfernt wurde.

Das Bauelement 2 ist ein Leistungselement, das im Betrieb gekühlt werden muß. Die Abwärme des Bauelements 2 wird daher über die metallisierte Fläche 4 abgeleitet. Wenn das Bauelement 2 sehr stark gekühlt werden muß, reicht die Fläche 4 hierzu nicht aus. Das Spritzgießteil 1 weist daher Ausnehmungen 5, 6 auf, die innen metallisiert sind und die metallisierte Fläche 4 mit weiteren, metallisierten und daher als Kühlflächen wirkenden Außenflächen 7, 8 thermisch und elektrisch leitend verbindet.

Sowohl die Kühlrippen 9, 10 als auch die Ausnehmungen 5, 6 wurden dabei beim oben erwähnten Metallisieren des Spritzgießteils 1 mit beschichtet.

Die Ausnehmungen 5, 6 können so stark metallisiert sein, daß sie durch die Metallisierung vollständig verschlossen sind. In diesem Fall kann besonders viel Wärme abgeführt werden. Die Metallisierung kann aber auch eine Dicke aufweisen, bei der die Ausnehmungen 5, 6 nur teilweise verschlossen sind.

Wenn nur eine relativ kleine zusätzliche Kühlfläche benötigt wird, ist die Ausnehmung 6 vorzugsweise in der Kühlfläche 9 angeordnet. Falls eine große zusätzliche Kühlfläche benötigt wird, weist das Spritzgießteil 1 vorzugsweise mehrere Kühlrippen 9, 10 mit metallisierten Außenflächen 4, 7, 8 auf, die über die an der Basis der Kühlrippen 9, 10 angeordneten Ausnehmungen 5 thermisch und elektrisch leitend verbunden sind.

Im gegebenen Ausführungsbeispiel sind die Wärmeleitelemente als Metallisierungen der Ausnehmungen 5, 6 ausgebildet. Anstelle der Metallisierungen könnten aber z. B. auch Lötverbindungen verwendet werden. In diesem Falle sind die Ausnehmungen 5, 6 durch die Lötverbindungen selbstverständlich vollständig verschlossen.

Abschließend sei noch erwähnt, daß anstelle eines Spritzgießteils auch ein anderer einstückiger, auf seiner Oberfläche zunächst elektrisch isolierender Schaltungsträger verwendet werden kann, z. B. ein auf seiner gesamten Oberfläche in geeigneter Weise eloxiertes Aluminium-Druckgußteil.

## Patentansprüche

1. Einstückiges Isolierteil, z. B. Kunststoffteil, insbesondere Spritzgießteil, mit mindestens einer metallisierten, als Kühlfläche wirkenden Außenfläche und mit Leiterzügen zur elektrisch leitenden Verbindung elektronischer Bauelemente, die auf dem Isolierteil angeordnet sind, **dadurch gekennzeichnet,** daß die Außenfläche (7,8) über mindestens eine mit einem Wärmeleitelement versehene Ausnehmung (5,6) des Isolierteils (1) mit mindestens einem der elektronischen Bauelemente (2) elektrisch und thermisch leitend verbunden ist.

2. Isolierteil nach Anspruch 1, **dadurch gekennzeichnet,** daß die Außenfläche (7,8) Teil einer Kühlrippe (9,10) ist und daß die Ausnehmung (5) an der Basis der Kühlrippe (9,10) angeordnet ist.

3. Isolierteil nach Anspruch 1, **dadurch gekennzeichnet,** daß die Außenfläche (7,8) Teil einer Kühlrippe (9,10) ist und daß die Ausnehmung (6) in der Kühlrippe (9,10) angeordnet ist.

4. Isolierteil nach Anspruch 1, 2 oder 3, **dadurch gekennzeichnet,** daß die Ausnehmung (5,6) durch das Wärmeleitelement vollständig verschlossen ist.

5. Isolierteil nach Anspruch 1, 2 oder 3, **dadurch gekennzeichnet,** daß die Ausnehmung (5,6) durch das Wärmeleitelement nur teilweise verschlossen ist.

6. Isolierteil nach einem der obigen Ansprüche, **dadurch gekennzeichnet,** daß das Wärmeleitelement als Metallisierung ausgebildet ist.

7. Isolierteil nach Anspruch 4, **dadurch gekennzeichnet,** daß das Wärmeleitelement als Lötverbindung ausgebildet ist.

8. Isolierteil nach einem der obigen Ansprüche, **dadurch gekennzeichnet,** daß es als mit einer Isolierschicht versehenes Metallteil, z. B. als eloxiertes Aluminium-Druckgußteil, ausgebildet ist.

## Claims

1. A single-piece insulating part, e.g. a plastics material part, in particular an injection-moulded part, with at least one metallised outer surface acting as a cooling surface and with conductors for electroconductively connecting electronic components which are arranged on the insulating part,
characterised in that the outer surface (7, 8) is thermally and electroconductively connected to at least one of the electronic components (2) via at least one recess (5, 6) of the insulating part (1) provided with a heat transfer element.

2. An insulating part according to claim 1,
characterised in that the outer surface (7, 8) is part of a cooling rib (9, 10) and the recess (5) is disposed at the base of the cooling rib (9, 10).

3. An insulating part according to claim 1,
characterised in that the outer surface (7, 8) is part of a cooling rib (9, 10) and the recess (6) is disposed within the cooling rib (9, 10).

4. An insulating part according to claim 1, 2 or 3,
characterised in that the recess (5, 6) is completely filled by the heat transfer element.

5. An insulating part according to claim 1, 2 or 3,
characterised in that the recess (5, 6) is only partially filled by the heat transfer element.

6. An insulating part according to one of the above claims, characterised in that the heat transfer element is formed by metallisation.

7. An insulating part according to claim 4,
characterised in that the heat transfer element is formed by a soldered connection.

8. An insulating part according to one of the above claims, characterised in that it is constructed as a metal part, for example as an anodised aluminium die-cast part, provided with an insulating layer.

## Revendications

1. Pièce isolante monobloc, par exemple pièce en matière plastique, notamment pièce moulée par injection, comportant au moins une surface extérieure métallisée et agissant en tant que surface de refroidissement, et des voies conductrices destinée à établir une liaison conductrice de l'électricité avec des composants électroniques, qui sont disposés sur la pièce isolante, caractérisée par le fait que la surface extérieure (7,8) est reliée de façon électriquement et thermiquement conductrice à au moins l'un des composants électroniques (2), par l'intermédiaire d'au moins un évidement (5,6) de la pièce isolante (1), qui est pourvu d'un élément thermoconducteur.

2. Pièce isolante suivant la revendication 1, caractérisée par le fait que la surface extérieure (7,8) fait partie d'une nervure de refroidissement (9,10) et que l'évidement (5) est disposé à la base de la nervure de refroidissement (9,10).

3. Pièce isolante suivant la revendication 1, caractérisée par le fait que la surface extérieure (7,8) fait partie d'une nervure de refroidissement (9,10) et que l'évidement (6) est disposé dans la nervure de refroidissement (9,10).

4. Pièce isolante suivant la revendication 1, 2 ou 3, caractérisée par le fait que l'évidement (5,6) est complètement fermé par l'élément thermoconducteur.

5. Pièce isolante suivant la revendication 1, 2 ou 3, caractérisée par le fait que l'évidement (5,6) est formé seulement partiellement par l'élément thermoconducteur.

6. Pièce isolante suivant l'une des revendications précédentes, caractérisée par le fait que l'élément thermoconducteur a la forme d'une métallisation.

7. Pièce isolante suivant la revendication 4, caractérisée par le fait que l'élément thermoconducteur a la forme d'une liaison brasée.

8. Pièce isolante suivant l'une des revendications précédentes, caractérisée par le fait qu'elle a la forme d'une pièce métallique, par exemple une pièce moulée sous pression en aluminium oxydé électrolytiquement, pourvue d'une couche isolante.
